(19) Europäisches Patentamt / European Patent Office / Office européen des brevets

(11) **EP 3 264 126 B1**

(12) **FASCICULE DE BREVET EUROPEEN**

(45) Date de publication et mention
de la délivrance du brevet:
**30.06.2021 Bulletin 2021/26**

(51) Int Cl.:
***G01R 33/34*** *(2006.01)*    ***G01R 33/345*** *(2006.01)*
***G01R 33/36*** *(2006.01)*

(21) Numéro de dépôt: **17179363.1**

(22) Date de dépôt: **03.07.2017**

(54) **ANTENNE VOLUMIQUE DESACCORDABLE POUR APPAREIL D'IMAGERIE PAR RESONANCE MAGNETIQUE NUCLEAIRE**

VERSTIMMBARE VOLUMENSPULE FÜR MRT-GERÄT

DETUNABLE VOLUME COIL FOR A NUCLEAR MAGNETIC RESONANCE IMAGING APPARATUS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.07.2016 FR 1656284**

(43) Date de publication de la demande:
**03.01.2018 Bulletin 2018/01**

(73) Titulaire: **Commissariat à l'Energie Atomique et aux Energies Alternatives
75015 Paris (FR)**

(72) Inventeurs:
• **LUONG, Michel
  92330 SCEAUX (FR)**
• **GIACOMINI, Eric
  61110 BRETONCELLES (FR)**

(74) Mandataire: **Cabinet Camus Lebkiri
25 rue de Maubeuge
75009 Paris (FR)**

(56) Documents cités:
**US-A1- 2002 145 427    US-A1- 2008 197 848
US-A1- 2010 060 283    US-B1- 6 633 161
US-B1- 6 791 328**

• SMITH J ET AL: "Active detuning of inductively coupled surface coils", INTERNATIONAL SOCIETY FOR MAGNETIC RESONANCE IN MEDICINE. SCIENTIFIC MEETING AND EXHIBITION. PROCEEDINGS, INTERNATIONAL SOCIETY FOR MAGNETIC RESONANCE IN MEDICINE, US, 7 mai 2005 (2005-05-07), page 323, XP002469317, ISSN: 1524-6965
• AKTHAM ASFOUR: "Characterization, performances and in-vivo validation of a new dual-frequency NMR sensor", BIOMEDICAL ENGINEERING AND INFORMATICS (BMEI), 2011 4TH INTERNATIONAL CONFERENCE ON, IEEE, 15 octobre 2011 (2011-10-15), pages 1055-1059, XP032071541, DOI: 10.1109/BMEI.2011.6098385 ISBN: 978-1-4244-9351-7
• VAUGHAN JT ET AL: "Detunable transverse electromagnetic (TEM) volume coil for high-field NMR", MAGNETIC RESONANCE IN MEDICINE, JOHN WILEY & SONS, INC, US, vol. 47, 1 janvier 2002 (2002-01-01), pages 990-1000, XP002470652, ISSN: 0740-3194, DOI: 10.1002/MRM.10141

EP 3 264 126 B1

**Description**

**DOMAINE TECHNIQUE**

Le domaine de l'invention est celui des antennes volumiques radiofréquences (« RF coil » en langue anglaise) à hautes fréquences et leur utilisation dans les appareils de Résonance Magnétique Nucléaire (RMN) pour l'homme ou l'animal, ainsi que leurs applications : Imagerie par Résonance Magnétique (IRM), Spectroscopie par Résonance Magnétique (SRM), ou encore imagerie du tenseur de diffusion.

L'invention concerne plus particulièrement les antennes volumiques à hautes fréquences émettrices simples générant un champ radiofréquence (RF) ayant une composante magnétique capable d'exciter les noyaux des atomes, en particulier les atomes d'hydrogène, au sein de l'échantillon placé dans l'antenne ainsi que les antennes volumiques à hautes fréquences réceptrices simples capable de capter le signal de relaxation du phénomène RMN.

L'invention concerne également les antennes permettant d'opérer alternativement sur deux (ou plus) noyaux différents, par exemple l'hydrogène et le sodium dans certaines études qui s'intéressent au métabolisme.

**ETAT DE LA TECHNIQUE**

Lorsque la fréquence de Larmor du signal RMN est élevée (par exemple supérieure à 100 MHz) et que la taille de l'objet observé (dénommé ci-après par le terme échantillon) est suffisamment petite pour que les inhomogénéités du champ radiofréquence (également appelées inhomogénéités de B1) restent limitées, il est souvent avantageux d'utiliser une antenne volumique pour l'excitation des spins dans la phase de transmission car ce type d'antenne présente un rendement nettement plus élevé et génère un DAS (débit d'absorption spécifique) plus faible par rapport à tout autre type d'antenne.

Pour la réception, il est également intéressant de pouvoir mettre en œuvre une seconde antenne dédiée à la réception, insérée dans la première. En effet, cette seconde antenne étant placée plus près de l'échantillon, la sensibilité s'en trouve améliorée. Par ailleurs, cette antenne peut être une antenne dite réseau constituée d'un réseau d'éléments de réception, ce qui permet l'imagerie rapide (dite aussi parallèle) à travers la mise en œuvre des techniques spécifiques dites de SENSE et GRAPPA qui exploitent la sensibilité différentiée de chaque élément pour reconstruire une image à partir de données sous-échantillonnées.

Cependant, cette stratégie d'utiliser une antenne pour la transmission et une antenne pour la réception au plus près de l'échantillon n'est possible qu'à condition de pouvoir désaccorder l'antenne de transmission pendant la phase de réception et inversement. Le désaccord d'un émetteur et/ou d'un récepteur radiofréquences s'avère également nécessaire dans les antennes multi-noyaux lorsque les fréquences de Larmor des différents noyaux sont proches ; en effet, il est nécessaire que les réseaux d'un noyau ne puissent pas interagir avec ceux d'un autre noyau.

Avec les antennes volumiques, on utilise un mode propre de résonance. Ce mode propre présente une polarisation linéaire d'un champ B1 associé à l'onde électromagnétique générée dans l'échantillon. Cette polarisation est dégénérée spatialement, c'est-à-dire qu'elle ne possède pas une direction privilégiée. Par conséquent, il devient possible d'exciter en quadrature de phase deux polarisations orthogonales à l'aide d'un coupleur hybride. On obtient alors une antenne volumique à polarisation circulaire. Les voies du coupleur hybride non-connectées à l'antenne forment un accès pour la transmission et un accès pour la réception. En vertu de la physique de la RMN, une antenne à polarisation circulaire est plus efficace (en transmission) ou plus sensible (en réception) d'un facteur racine carré de deux en champ par rapport à une antenne à polarisation linéaire.

Les antennes volumiques sont généralement de deux types : les « cages d'oiseau » (birdcage en langue anglaise) et les TEM (pour transverse électrique et magnétique).

Afin de combiner une antenne volumique en transmission avec une antenne réseau en réception, il est indispensable de désaccorder l'antenne d'émission pendant la phase de réception du signal pour que le réseau de réception puisse conserver ses caractéristiques propres.

Toutefois, il est assez difficile de modifier la fréquence de résonance d'un mode propre sans détériorer le rendement de ce mode. Généralement, on cherche à ajouter ou à retirer une réactance sur chaque tige longitudinale formant des conducteurs longitudinaux de la ligne transmission de l'antenne volumique.

A cette fin, il a été proposé d'utiliser une diode PIN (pour « positive intrinsic negative » en langue anglaise) en parallèle ou en série avec un condensateur, ou avec une bobine d'auto-induction, sur chaque conducteur longitudinal de la ligne de transmission pour modifier l'impédance et donc pour désaccorder l'antenne volumique de type TEM, la diode PIN jouant le rôle d'un interrupteur (ouvert ou fermé) contrôlé électriquement ([1] Vaughan, J.T., Adriany, G., Garwood, M., Yacoub, E., Duong, T., DelaBarre, L., Andersen, P. and Ugurbil, K. (2002), Detunable transverse electromagnetic (TEM) volume coil for high-field NMR. Magn Reson Med, 47: 990-1000. doi: 10.1002/mrm.10141).

Toutefois, le type de montage proposé n'est pas entièrement satisfaisant car il engendre deux difficultés selon la manière dont la diode PIN est mise en œuvre. En effet, lorsque la diode PIN est passante (i.e. interrupteur fermé) au cours de la phase de transmission, le courant radiofréquence, qui génère le champ B1 utile, traverse en partie la diode PIN qui présente malheureusement une résistance résiduelle non nulle (typiquement de l'ordre de 0,5 ohm). En raison du fort courant radiofréquence qui circule dans le résonateur que constitue l'antenne et du fait que la puissance dissipée est égale à

$$\frac{1}{2}\mathbb{2}^2,$$

, cette configuration de la diode PIN se traduira par une perte significative de rendement pour l'antenne. De plus, lorsque la diode PIN est bloquée (interrupteur ouvert) pendant la transmission, un autre problème apparaît. En effet, la tension d'avalanche de la diode n'est pas infinie. Pour une diode PIN de dimensions compatibles avec l'espace disponible pour réaliser une antenne volumique, par exemple destinée aux rongeurs à un champ statique B0 de 17 T, la tension d'avalanche est alors d'environ 500 V. Or, cette tension peut être dépassée dans une antenne fonctionnant comme un circuit résonateur où des surtensions apparaissent localement et où les puissances radiofréquences mises en jeu avoisinent le kilowatt. Une fois la tension d'avalanche dépassée, l'antenne se comporte dans son ensemble de manière non-linéaire ce qui exclut son utilisation en IRM ou SRM.

Le document US210/0060283 décrit une autre solution permettant de désaccorder une antenne volumique radiofréquence au moyen d'un circuit de désaccord apte à désaccorder sans contact au moyen d'une boucle refermée par une diode PIN servant de moyen de commutation.

**EXPOSE DE L'INVENTION**

Dans ce contexte, la présente invention vise à résoudre les problèmes mentionnés précédemment en proposant une solution permettant de désaccorder une antenne volumique tout en conservant le rendement initial de celle-ci.

A cette fin, l'invention concerne une antenne volumique radiofréquence, adaptée à une utilisation dans un appareil de résonance magnétique nucléaire pour la transmission de signaux RMN, comportant une pluralité de conducteurs longitudinaux positionnés selon un axe longitudinal et un circuit de désaccord pour modifier la fréquence de résonance du mode propre de ladite antenne apte à désaccorder ladite antenne sans contact avec lesdits conducteurs longitudinaux, ledit circuit de désaccord étant composé par une pluralité de circuits résonants présentant un dispositif de commutation, ladite pluralité de circuits résonants résonant :

- à une première fréquence de résonance proche de la fréquence de résonance du mode propre de ladite antenne lorsque le moyen de commutation est en position fermée de manière à induire par effet inductif une réactance sur chaque conducteur longitudinal et à modifier la fréquence de résonance du mode propre de ladite antenne ;
- à une deuxième fréquence de résonance supérieure ou inférieure à la fréquence de résonance du mode propre de ladite antenne de manière à minimiser le couplage entre le circuit de désaccord et les conducteurs longitudinaux lorsque ledit moyen de commutation est en position ouverte,

ladite antenne volumique étant caractérisée en ce que l'antenne est une antenne quart-d'onde et en ce que les circuits résonants (8) sont positionnés longitudinalement dans l'antenne selon l'axe longitudinal à une position où le champ magnétique B1 est maximal.

On entend par l'expression « fréquence de résonance proche de la fréquence de résonance du mode propre de l'antenne » une fréquence proche à moins de cinq bandes passantes de la fréquence de résonance de l'antenne, et avantageusement à moins de trois bandes passantes.

L'antenne selon l'invention peut également présenter une ou plusieurs des caractéristiques ci-dessous, considérées individuellement ou selon toutes les combinaisons techniquement possibles :

- lesdits circuits résonants sont formés par une boucle conductrice refermée par ledit moyen de commutation et par un condensateur monté en série avec ledit moyen de commutation ;

- ledit moyen de commutation est une diode PIN ;

- ledit moyen de commutation est alimenté à travers deux bobines d'arrêt ;

- lesdits moyens de commutation de ladite pluralité de circuits résonants sont mis en série et pilotés par un même signal ;

- ladite antenne radiofréquence est une antenne TEM comportant une pluralité de conducteurs longitudinaux court-circuités sur un blindage périphérique à travers une couronne conductrice ;

- les circuits résonants sont positionnés longitudinalement au niveau de la couronne conductrice ;

- les conducteurs longitudinaux sont des conducteurs non coaxiaux ; dans une antenne TEM volumique classique, les conducteurs longitudinaux ont une structure coaxiale dans le sens où ils sont réalisés avec un conducteur interne séparé d'un conducteur externe par un matériau isolant. On utilise généralement à cet effet un câble coaxial semi-rigide. Cette structure se retrouve sur l'intégralité ou la quasi-intégralité de la longueur du conducteur longitudinal. Nous entendons donc par "non coaxial" l'absence de cette structure ;

- lesdits conducteurs longitudinaux de ladite pluralité sont formés par un premier tube et par un deuxième tube coulissant à l'intérieur du premier tube, la longueur desdits conducteurs longitudinaux étant ajustable par coulissement relatif du premier tube et du deuxième tube ; cette structure de tubes coulissants pour régler l'antenne volumique est différente d'une structure coaxiale classique dans le sens où les deux tubes coulissants sont en contact électrique l'un avec l'autre et que cette géométrie concentrique des deux tubes ne se retrouve que sur une toute petite portion du conducteur longitudinal. Les deux conducteurs longitudinaux sont donc bien différents d'une structure coaxiale telle que décrite précédemment ;

- ladite antenne comporte quatre accès formés par des câbles coaxiaux reliés à quatre conducteurs longitudinaux séparés chacun par un angle de 90°, lesdits accès permettant de coupler l'antenne par effet inductif.

## BREVES DESCRIPTIONS DES FIGURES

D'autres caractéristiques et avantages de l'invention ressortiront plus clairement de la description qui en est donnée ci-dessous, à titre indicatif et nullement limitatif, en référence aux figures annexées, parmi lesquelles :

- la figure 1 est un exemple de réalisation d'une antenne volumique de type TEM, destinée à l'IRM de la tête d'une souris ;
- la figure 2 représente schématiquement un exemple de réalisation d'un circuit de désaccord d'une antenne volumique selon l'invention ;
- la figure 3 illustre la courbe de réflexion de l'antenne volumique illustrée à la figure 1 lorsque le dispositif de commutation est en position ouverte ;
- la figure 4 illustre la courbe de réflexion de l'antenne volumique illustrée à la figure 1 lorsque le dispositif de commutation est en position fermée ;
- la figure 5 est un graphique comparatif illustrant deux cartes de champ entre une antenne volumique non équipée d'un circuit de désaccord selon l'invention et d'une antenne volumique comportant un circuit de désaccord selon l'invention.

## DESCRIPTION D'AU MOINS UN MODE DE REALISATION

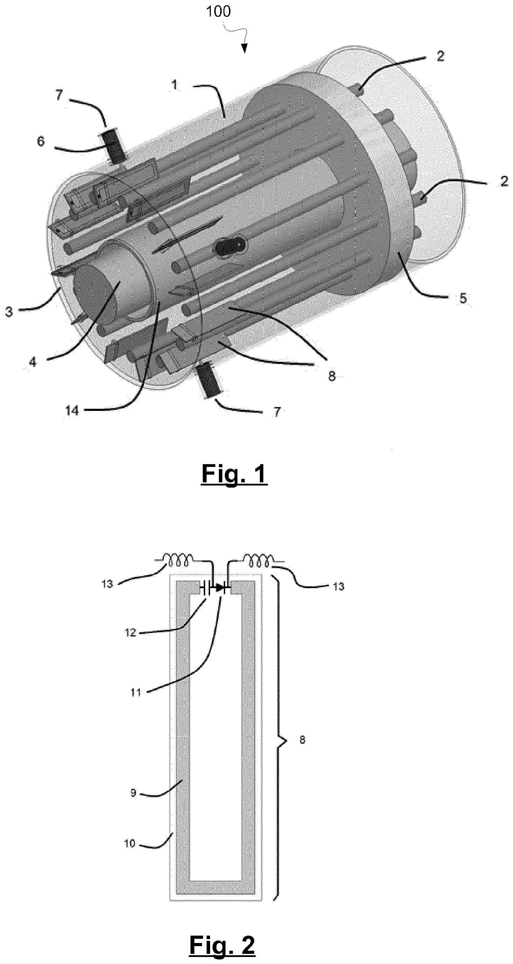

La figure 1 est un exemple de réalisation d'une antenne volumique 100 de type TEM, destinée à l'IRM de la tête d'une souris à 17 Teslas. Dans cet exemple de réalisation, l'antenne est un résonateur dit « lambda/4 » ou encore résonateur quart-d'onde.
La ligne de transmission de l'antenne volumique 100 est formée par un blindage périphérique 1, présentant un diamètre de 70 mm, et par une pluralité de conducteurs longitudinaux 2, agencés au niveau d'une région périphérique de l'antenne 100, présentant par exemple un diamètre de 4 mm ; l'axe longitudinal des conducteurs longitudinaux 2 étant placé par exemple à 7,5 mm du blindage périphérique 1.
Dans l'exemple de réalisation illustrée à la figure 1, l'antenne 100 présente avantageusement douze conducteurs longitudinaux 2. Toutefois, l'invention est également applicable à une ligne de transmission d'une antenne présentant huit ou seize conducteurs longitudinaux 2.
La ligne de transmission de l'antenne propage un mode quasi-TEM caractérisé en ce que le champ magnétique est particulièrement uniforme au centre de la ligne de transmission, i.e. proche de l'axe de symétrie de l'antenne à savoir l'axe du cylindre 4. Pour obtenir une antenne volumique TEM, il est nécessaire de court-circuiter tous les conducteurs longitudinaux 2 d'une longueur environ égale au quart de la longueur d'onde dans le vide, i.e. environ 100 mm, sur le blindage périphérique 1 à travers la couronne conductrice 3. Ainsi, le champ magnétique B1 est maximal du côté de la couronne conductrice 3 et minimal du côté opposé à la couronne conductrice 3 et inversement pour le champ électrique. Ainsi, du fait de la très faible valeur du champ électrique au niveau de la couronne conductrice 3, l'antenne quart-d'onde 100 est quasiment insensible à l'échantillon 4 placé au centre de l'antenne 100.
Un support 5, par exemple en mousse dure, permet de solidariser les différents conducteurs longitudinaux 2 du côté opposé à la couronne conductrice 3 et de les maintenir en position. Pour exciter le résonateur, l'antenne 100 comporte également un câble coaxial 6 pour réaliser un couplage inductif. L'âme du câble coaxial est connectée à un conducteur longitudinal 2 et la tresse de blindage du câble coaxiale est connectée au blindage périphérique 1 de l'antenne 100.
Toutefois, en pratique, la polarisation linéaire ainsi produite présente une légère asymétrie. En effet, le champ magnétique B1 est plus fort du côté du couplage inductif. Pour minimiser cette asymétrie, il convient de coupler simultanément deux conducteurs 2 en vis-à-vis en déphasant de 180° les signaux qui alimentent chacun des deux accès 7 ainsi créés. L'emplacement du point de contact entre l'âme du câble 6 et le conducteur 2 est choisi de manière à ce chaque accès soit adapté par rapport à 50 ohms. Dans le cas de cet exemple de réalisation, il se situe à 14 mm à partir de la couronne conductrice 3. Enfin, pour obtenir une polarisation circulaire, il suffit d'alimenter en quadrature de phase une autre paire d'accès placée orthogonalement à la première.
Pour obtenir un fonctionnement optimal de l'antenne 100, il est nécessaire de régler indépendamment chaque conducteur 2. En pratique, chaque conducteur 2 est constitué de deux tubes préférentiellement en laiton, qui coulissent l'un dans l'autre, permettant ainsi de régler leur longueur totale. Un premier tube long, mesurant environ 4/5e de la longueur totale, est soudé à la couronne 3 et est solidaire du support 5 tandis que le deuxième tube court mesurant environ 2/5e de la longueur totale, coulisse dans le premier tube long (non visible sur la figure 1) avec un jeu serré.

Le réglage des conducteurs longitudinaux 2 se déroule en deux étapes. Dans un premier temps, les conducteurs longitudinaux 2 sont réglés individuellement pour qu'ils résonnent à la fréquence de Larmor. Pour annuler le couplage du conducteur longitudinal 2 à régler avec les quatre conducteurs longitudinaux 2 voisins les plus proches, on insère temporairement quatre tiges dans les tubes courts de façon à les faire résonner à une fréquence plus basse. Pour déterminer la fréquence de résonance du conducteur 2 en cours de réglage, on ausculte par transmission le résonateur formé uniquement par le conducteur 2. A cette fin, on utilise deux éléments d'auscultation constitués par un câble coaxial terminé par une petite boucle (typiquement 3 mm de diamètre) et un câble coaxial dénudé (l'âme dépassant typiquement de 5 mm de la tresse) et placés respectivement du côté de la couronne 3 et du côté opposé le long du conducteur 2. La boucle réalise alors un couplage magnétique faible tandis que le câble coaxial dénudé réalise un couplage électrique faible. La mesure du coefficient de transmission à l'aide d'un analyseur de réseau entre les deux éléments d'auscultation permet d'identifier la fréquence de résonance qui se manifeste par un maximum dans la transmission. On procède ainsi conducteur après conducteur. Une fois que tous les conducteurs 2 ont été réglés à la fréquence de Larmor, on relève la fréquence de résonance de l'antenne volumique ainsi constituée à travers les accès 7, soit par une mesure de réflexion, soit par une mesure de transmission sur les accès 7 en vis-à-vis. En raison du couplage entre les résonateurs que constituent les conducteurs longitudinaux 2, la fréquence de résonance de l'antenne volumique est plus faible que la fréquence de résonance des conducteurs longitudinaux 2 pris isolément. On note alors Δf la différence entre la fréquence de Larmor et la fréquence de résonance effective de l'antenne. Ensuite, on recommence le réglage de chaque conducteur longitudinal 2 en ciblant la fréquence de Larmor augmentée de Δf. A l'issue de cette seconde étape, l'antenne volumique 100 est réglée et résonne à la fréquence de Larmor.

L'antenne volumique comporte également un circuit de désaccord pour réaliser un désaccord sans contact des conducteurs longitudinaux 2. Le circuit de désaccord est formé par une pluralité d'éléments de désaccord 8. Dans l'exemple de réalisation illustré à la figue 1 dans lequel l'antenne volumique comporte douze conducteurs longitudinaux 2, les éléments de désaccord 8 sont placés à une égale distance entre chaque conducteur longitudinal 2 et sont situés dans une région périphérique de l'antenne, proche du blindage périphérique 1.

Lorsque l'antenne volumique comporte huit conducteurs longitudinaux 2, il est en revanche nécessaire de placer un élément de désaccord 8 près de chaque conducteur 2, typiquement à 3 mm, et non plus à égale distance entre chaque conducteur 2. En effet, dans le cas contraire, le couplage inductif ne serait pas assez important pour produire un désaccord en fréquence suffisant.

De plus, les éléments de désaccord 8, ou circuits résonants, sont positionnés dans la zone utile de l'antenne volumique et donc dans la région où les champs magnétiques sont les plus importants, et inversement dans la région où les champs électriques sont les plus faibles. Cela permet notamment de maintenir les performances de l'antenne volumique haute fréquence.

Ainsi, dans le cas d'une antenne volumique lambda/4, le champ magnétique B1 est maximal du côté de la couronne conductrice 3 et minimal du côté opposé à la couronne conductrice 3 et inversement pour le champ électrique. C'est pourquoi les éléments de désaccord 8 sont situés à l'extrémité de l'antenne 100 proche de la couronne conductrice 3, comme représenté dans l'exemple de réalisation illustré à la figure 1.

La figure 2 illustre plus précisément un élément de désaccord 8 constituant le circuit de désaccord de l'antenne volumique selon l'invention.

Chaque élément de désaccord 8 du circuit de désaccord forme un circuit résonant constitué par une boucle rectangulaire 9 réalisée par une piste conductrice, par exemple en cuivre, positionnée sur un circuit imprimé 10. A titre d'exemple, la piste rectangulaire présente une longueur de 23mm, une largeur de 5 mm ainsi qu'une largeur de piste de 1 mm. Le circuit imprimé 10, de faible épaisseur, peut être réalisé en composite de résine époxy renforcé de fibre de verre de type FR-4 (pour « Flame Résistant 4 » en langue anglaise) ou plus avantageusement encore, en matériau diélectrique de plus faible perte.

La boucle rectangulaire 9 est refermée, au niveau de sa partie haute, par une diode PIN 11 montée en série avec un condensateur 12, par exemple de 1,8 pF. La diode PIN 11 est pilotée au travers de deux bobines d'arrêt 13, typiquement de 1 μH. Chaque diode PIN 11 avec les deux bobines d'arrêt 13 de l'ensemble des éléments de désaccord peuvent être alimentées en série par un seul signal de contrôle.

Avantageusement, les éléments de désaccord 8 sont placés longitudinalement de manière à ce que leur extrémité supérieure, formée par le haut de la boucle, se trouvent en saillie par rapport à la couronne conductrice 3. Un tel positionnement permet ainsi de facilité l'accessibilité aux diodes PIN 11 et aux condensateurs 12 par la partie avant de l'antenne 100 notamment pour les besoins de maintenance.

Le centre de l'antenne volumique 100 est formé par un tube central 14 assure la séparation entre l'échantillon 4 et les autres éléments périphériques de l'antenne volumique 100. Le tube central 14 est avantageusement en matière plastique et présente des caractéristiques de faibles pertes diélectrique.

Lorsque l'antenne volumique 100 selon l'invention fonctionne en transmission, les diodes PIN 11 sont bloquées. Une tension négative de 30V est alors appliquée entre l'anode et la cathode de la diode PIN 11 de chaque élément de désaccord 8. Ainsi, la diode PIN 11 se comporte comme un condensateur de très faible valeur (typiquement de l'ordre de 0,5 pF) mis en série avec le condensateur 12. La capacité de l'ensemble est alors de 0,4 pF. La piste conductrice de la boucle rectangulaire 9 présente une inductance propre, typiquement environ 24 nH et la boucle rectangulaire de l'élément de désaccord 8 résonne à une fréquence proche de 1,6 GHz.

Cette fréquence de résonance est donnée par la relation :

$$f_0 = \frac{1}{2\pi\sqrt{LC}},$$

où : L est l'inductance propre ;
C est la valeur de la capacité.

Ainsi, compte-tenu de l'écart important avec la fréquence de Larmor (730 MHz), le couplage entre les éléments de désaccord 8 et les conducteurs 2 de l'antenne, demeure infiniment faible. Tout se passe comme si les éléments de désaccord 8 étaient absents. Ainsi, le courant radiofréquence induit sur la piste conductrice de la boucle étant également infiniment faible, il n'existe aucun risque que la tension d'avalanche des diodes PIN 11 soit franchie.

En revanche, lorsque les diodes PIN 11 sont alimentées par un courant commun, par exemple de 100mA, les diodes se mettent à conduire et à se comporter comme une résistance résiduelle de 0,5 Ohm. La capacité de l'ensemble passe alors à 2 pF faisant résonner la boucle à une fréquence de 765 MHz, c'est-à-dire suffisamment proche de la fréquence de Larmor pour ramener une réactance suffisamment forte sur les conducteurs 2 de l'antenne 100.

Le circuit de désaccord selon l'invention permet ainsi de désaccorder une antenne volumique sans contact avec les conducteurs longitudinaux et en ajoutant une réactance par couplage magnétique sur chaque conducteur longitudinal d'une antenne volumique tout en conservant le rendement initial de ladite antenne.

Une simulation numérique à partir du code Ansys ® HFSS (pour High Frequency Electromagnetic Field Simulation en langue anglaise) basé sur la méthode des éléments finis permet de caractériser à la fois l'amplitude de désaccord en fréquence réalisé par le circuit de désaccord et à la fois une perte éventuelle de rendement liée à la présence du circuit de désaccord présenté précédemment.

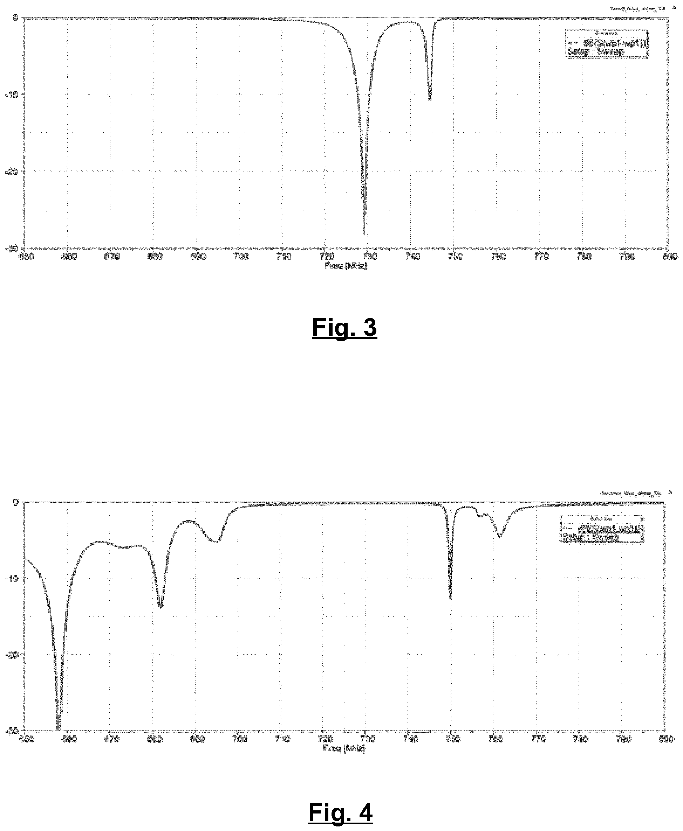

A cet effet, la figure 3 illustre une courbe de réflexion sur un des quatre accès 7 de l'antenne volumique 100 présenté précédemment lorsque celle-ci est accordée et fonctionne de manière nominale. Le mode de résonance utile est celui qui résonne près de 730 MHz. Le mode qui résonne à environ 15 MHz au-dessus de la fréquence de Larmor ne présente pas la distribution de champ B1 la plus uniforme. Par symétrie, les courbes de réflexion doivent être quasiment identiques lorsque l'antenne est bien réglée selon la méthode présentée précédemment.

La figure 4 montre la courbe sur le même accès 7 lorsque les diodes 11 sont rendues passantes. On observe alors que le mode utile est très décalé et à une fréquence bien plus basse, autour de 660 MHz. On notera également l'absence de mode de résonance autour de 730 MHz, la fréquence de Larmor.

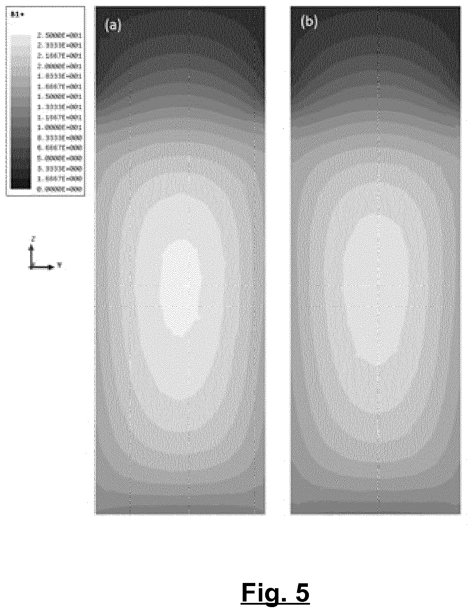

La figure 5 illustre deux cartes de champ magnétique de la polarisation circulaire utilisée en transmission (dit de B1+) entre une antenne non équipée (carte (a)) du circuit de désaccord selon l'invention et une antenne équipé (carte (b)) du circuit de désaccord selon l'invention. Les champs sont tracés sur une coupe dans l'échantillon 4. On observe très peu de différence sur ces cartes. Une analyse quantitative montre que la présence des éléments de désaccord 8 du circuit de désaccord ne réduit que de 5% le champ dans la zone la mieux éclairée de l'échantillon 4 par rapport à une antenne volumique dépourvue de circuit de désaccord.

## Revendications

1. Antenne volumique radiofréquence (100), adaptée à une utilisation dans un appareil de résonance magnétique nucléaire (RMN) pour la transmission de signaux RMN, comportant une pluralité de conducteurs longitudinaux (2) positionnés selon un axe longitudinal et un circuit de désaccord pour modifier la fréquence de résonance du mode propre de ladite antenne (100) et apte à désaccorder ladite antenne sans contact avec lesdits conducteurs longitudinaux (2), ledit circuit de désaccord étant composé d'une pluralité de circuits résonants (8) présentant un dispositif de commutation (11), ladite pluralité de circuits résonants (8) résonant :

   - à une première fréquence de résonance proche de la fréquence de résonance du mode propre de ladite antenne lorsque le moyen de commutation (11) est en position fermée de manière à induire par effet inductif une réactance sur chaque conducteur longitudinal (2) et à modifier la fréquence de résonance du mode propre de ladite antenne (100) ;
   - à une deuxième fréquence de résonance supérieure ou inférieure à la fréquence de résonance du mode propre de ladite antenne lorsque le moyen de commutation (11) est en position ouverte de manière à minimiser le couplage entre le circuit de désaccord et les conducteurs longitudinaux (2), ladite antenne volumique étant **caractérisée en ce que** l'antenne est une antenne quart-d'onde et **en ce que** les circuits résonants (8) sont positionnés longitudinalement dans l'antenne (100) selon l'axe longitudinal à une position où le champ magnétique B1 est maximal.

2. Antenne volumique radiofréquence (100) selon la revendication 1 **caractérisée en ce que** lesdits circuits résonants (8) sont formés par une boucle conductrice (9) refermée par ledit moyen de commutation (11) et par un condensateur (12) monté en série avec ledit moyen de commutation (11).

3. Antenne volumique radiofréquence (100) selon l'une des revendications 1 à 2 **caractérisée en ce que** ledit moyen de commutation (11) est une diode PIN.

4. Antenne volumique radiofréquence (100) selon la revendication 3 **caractérisée en ce que** ledit moyen de commutation (11) est alimenté à travers deux bobines d'arrêt (13).

5. Antenne volumique radiofréquence (100) selon l'une des revendications 3 4 à 4 **caractérisée en ce que** lesdits moyens de commutation (11) de ladite pluralité de circuits résonants (8) sont mis en série et pilotés par un même signal.

6. Antenne volumique radiofréquence (100) selon l'une des revendications 1 à 5 **caractérisée en ce que** ladite antenne radiofréquence (100) est une antenne TEM comportant une pluralité de conducteurs longitudinaux (2) court-circuités sur un blindage périphérique (1) à travers une couronne conductrice (3).

7. Antenne volumique radiofréquence (100) selon la revendication 6 **caractérisée en ce que** les circuits résonants (8) sont positionnés longitudinalement au niveau de la couronne conductrice (3).

8. Antenne volumique radiofréquence (100) selon l'une des revendications 1 à 7 **caractérisée en ce que** les conducteurs longitudinaux (2) sont des conducteurs non coaxiaux.

9. Antenne volumique radiofréquence (100) selon l'une des revendications 1 à 8 **caractérisée en ce que** lesdits conducteurs longitudinaux (2) de ladite pluralité sont formés par un premier tube et par un deuxième tube coulissant à l'intérieur du premier tube, la longueur desdits conducteurs longitudinaux (2) étant ajustable par coulissement relatif du premier tube et du deuxième tube.

10. Antenne volumique radiofréquence (100) selon l'une des revendications 1 à 9 **caractérisée en ce que** ladite antenne comporte quatre accès (7) formés par des câbles coaxiaux reliés à quatre conducteurs longitudinaux (2) séparés chacun par un angle de 90°, lesdits accès (7) permettant de coupler l'antenne par effet inductif.

**Patentansprüche**

1. Funkfrequenz-Volumenantenne (100), die für eine Verwendung in einem kernmagnetischen Resonanzgerät (RMN) zur Übertragung von RMN-Signalen geeignet ist, umfassend eine Vielzahl von länglichen Leitern (2), die gemäß einer Längsachse positioniert sind, und eine Verstimmungsschaltung zum Abändern der Resonanzfrequenz des eigenen Modus der genannten Antenne (100) und die zum Verstimmen der genannten Antenne ohne Kontakt mit den genannten länglichen Leitern (2) geeignet ist, wobei die genannte Verstimmungsschaltung aus einer Vielzahl von Resonanzschaltungen (8) gebildet ist, die eine Schaltvorrichtung (11) aufweisen, wobei die genannte Vielzahl von Resonanzschaltungen (8) mitschwingt:

- in einer ersten Resonanzfrequenz, die der Resonanzfrequenz des eigenen Modus der genannten Antenne nahe ist, wenn das Kommunikationsmittel (11) derart in geschlossener Position ist, dass per induktivem Effekt eine Reaktanz auf jedem länglichen Leiter (2) induziert ist und die Resonanzfrequenz des eigenen Modus der genannten Antenne (100) abgeändert ist;
- in einer zweiten Resonanzfrequenz, die größer oder kleiner ist als die Resonanzfrequenz des eigenen Modus der genannten Antenne, wenn das Umschaltmittel (11) derart in offener Position ist, dass die Kopplung zwischen der Verstimmungsschaltung und den länglichen Leitern (2) minimiert ist,

wobei die genannte Volumenantenne **dadurch gekennzeichnet ist, dass** die Antenne eine Viertelwellen-Antenne ist und dass die Resonanzschaltungen (8) länglich in der Antenne (100) gemäß der Längsachse in einer Position positioniert sind, in der das Magnetfeld B1 maximal ist.

2. Funkfrequenz-Volumenantenne (100) gemäß Anspruch 1, **dadurch gekennzeichnet, dass** die genannten Resonanzschaltungen (8) von einer Leiterschleife (9), die von dem genannten Umschaltmittel (11) gebildet sind, und von einem Kondensator (12), der in Serie mit dem genannten Umschaltmittel (11) montiert ist, gebildet sind.

3. Funkfrequenz-Volumenantenne (100) gemäß einem der Ansprüche 1 bis 2, **dadurch gekennzeichnet, dass** das genannte Umschaltmittel (11) eine Diode PIN ist.

4. Funkfrequenz-Volumenantenne (100) gemäß Anspruch 3, **dadurch gekennzeichnet, dass** das genannte Umschaltmittel (11) durch zwei Sperrdrosseln (13) versorgt ist.

**5.** Funkfrequenz-Volumenantenne (100) gemäß einem der Ansprüche 3 bis 4, **dadurch gekennzeichnet, dass** die genannten Umschaltmittel (11) der genannten Vielzahl von Resonanzschaltungen (8) in Serie geschaltet und von einem und demselben Signal gesteuert sind.

**6.** Funkfrequenz-Volumenantenne (100) gemäß einem der Ansprüche 1 bis 5, **dadurch gekennzeichnet, dass** die genannte Funkfrequenz-Antenne (100) eine Antenne TEM ist, die eine Vielzahl von länglichen Leitern (2) umfasst, die auf einer umlaufenden Abschirmung (1) durch eine Leiterkrone (3) kurzgeschlossen sind.

**7.** Funkfrequenz-Volumenantenne (100) gemäß Anspruch 6, **dadurch gekennzeichnet, dass** die genannten Resonanzschaltungen (8) länglich an der Leiterkrone (3) positioniert sind.

**8.** Funkfrequenz-Volumenantenne (100) gemäß einem der Ansprüche 1 bis 7, **dadurch gekennzeichnet, dass** die länglichen Leiter (2) nicht koaxiale Leiter sind.

**9.** Funkfrequenz-Volumenantenne (100) gemäß einem der Ansprüche 1 bis 8, **dadurch gekennzeichnet, dass** die genannten länglichen Leiter (2) der genannten Vielzahl durch eine erste Röhre und durch eine zweite Röhre geformt sind, die im Innern der ersten Röhre gleitet, wobei die Länge der genannten länglichen Leiter (2) durch relatives Gleiten der ersten Röhre und der zweiten Röhre einstellbar ist.

**10.** Funkfrequenz-Volumenantenne (100) gemäß einem der Ansprüche 1 bis 9, **dadurch gekennzeichnet, dass** die genannte Antenne vier Zugänge (7) umfasst, die von den koaxialen Kabeln geformt sind, die mit vier länglichen Leitern (2) verbunden sind, die jeweils von einem Winkel von 90 °getrennt sind, wobei die genannten Zugänge (7) das Koppeln der Antenne per induktivem Effekt ermöglichen.

**Claims**

**1.** Radiofrequency volume coil (100), suitable for use in a nuclear magnetic resonance apparatus (NMR) for the transmission of NMR signals, comprising a plurality of longitudinal conductors (2) positioned along a longitudinal axis and a detuning circuit to modify the resonance frequency of the natural mode of said coil (100) and able to detune said coil without contact with said longitudinal conductors (2), said detuning circuit being comprised of a plurality of resonant circuits (8) having a switching device (11), said plurality of resonant circuits (8) resonating:

- at a first resonance frequency close to the resonance frequency of the natural mode of said coil when the means of switching (11) is in the closed position in such a way as to induce by the inductive effect a reactance on each longitudinal conductor (2) and to modify the resonance frequency of the natural mode of said coil (100);
- at a second resonance frequency higher than or less than the resonance frequency of the natural mode of said coil when the means of switching (11) is in the open position so as to minimise the coupling between the detuning circuit and the longitudinal conductors (2),

said volume coil being **characterised in that** the coil is a 1/4 wave coil and **in that** the resonant circuits (8) are positioned longitudinally in the coil (100) along the longitudinal axis at a position where the magnetic field B1 is maximal.

**2.** Radiofrequency volume coil (100) according to claim 1 **characterised in that** said resonant circuits (8) are formed by a conductive loop (9) closed by said means of switching (11) and by a capacitor (12) mounted in series with said means of switching (11).

**3.** Radiofrequency volume coil (100) according to one of claims 1 to 2 **characterised in that** said means of switching (11) is a PIN diode.

**4.** Radiofrequency volume coil (100) according to claim 3 **characterised in that** said means of switching (11) is powered through two choke coils (13).

**5.** Radiofrequency volume coil (100) according to one of claims 3 to 4 **characterised in that** said means of switching (11) of said plurality of resonant circuits (8) are put in series and are controlled by the same signal.

**6.** Radiofrequency volume coil (100) according to one of claims 1 to 5 **characterised in that** said radiofrequency coil (100) is a TEM coil comprising a plurality of short-circuited longitudinal conductors (2) on a peripheral shielding (1) through a conductive crown (3).

**7.** Radiofrequency volume coil (100) according to claim 6 **characterised in that** the resonant circuits (8) are positioned longitudinally at the conductive crown (3).

**8.** Radiofrequency volume coil (100) according to one of claims 1 to 7 **characterised in that** the longitudinal conductors (2) are non-coaxial conductors.

**9.** Radiofrequency volume coil (100) according to one of claims 1 to 8 **characterised in that** said longitudinal conductors (2) of said plurality are formed by a first tube and by a second tube sliding inside the first tube, the length of said longitudinal conductors (2) being adjustable by sliding with respect to the first tube and the second tube.

10. Radiofrequency volume coil (100) according to one of claims 1 to 9 **characterised in that** said coil comprises four accesses (7) formed by coaxial cables connected to four longitudinal conductors (2) each separated by an angle of 90°, said accesses (7) making it possible to couple the coil by the inductive effect.

100

7
6
1
2
2
3
4
14
5
8
7
8

**Fig. 1**

13
12
11
9
10
13
8

**Fig. 2**

**Fig. 3**

**Fig. 4**

**Fig. 5**

## RÉFÉRENCES CITÉES DANS LA DESCRIPTION

### Documents brevets cités dans la description

- US 2100060283 A

### Littérature non-brevet citée dans la description

- **VAUGHAN, J.T. ; ADRIANY, G. ; GARWOOD, M. ; YACOUB, E. ; DUONG, T. ; DELABARRE, L. ; ANDERSEN, P. ; UGURBIL, K.** Detunable transverse electromagnetic (TEM) volume coil for high-field NMR. *Magn Reson Med,* 2002, vol. 47, 990-1000